# EUROPEAN PATENT SPECIFICATION

(11) **EP 3 032 596 B1**
(45) Date of publication and mention of the grant of the patent: **01.03.2017**
(21) Application number: 15192218.4
(22) Date of filing: 29.10.2015
(51) Int. Cl.: H01L 35/08, H01L 35/32

(54) **THERMOELECTRIC CONVERSION MODULE AND THERMOELECTRIC CONVERSION SYSTEM**
MODUL FÜR THERMOELEKTRISCHE UMWANDLUNG UND SYSTEM FÜR THERMOELEKTRISCHE UMWANDLUNG
MODULE ET SYSTÈME DE CONVERSION THERMOÉLECTRIQUE

(30) Priority: 09.12.2014 JP 2014248507; 18.08.2015 JP 2015160741
(43) Date of publication of application: 15.06.2016
(73) Proprietor: Panasonic Intellectual Property Management Co., Ltd., Osaka-shi, Osaka 540-6207 (JP)
(72) Inventor: TANAKA, Junya, Osaka, 540-6207 (JP); MAESHIMA, Satoshi, Osaka, 540-6207 (JP)
(74) Representative: Vigand, Philippe

(56) References cited:
- EP-A1- 2 207 213
- CN-A- 103 219 457
- US-A1- 2010 252 084

## Description

### BACKGROUND

### 1. Technical Field

The present disclosure relates to a thermoelectric conversion module and a thermoelectric conversion system.

### 2. Description of Related Art

A related-art thermoelectric conversion module disclosed in JP-A-2009-200507 (Patent Document 1) is shown in Fig. 7. P-type thermoelectric conversion devices 103 and N-type thermoelectric conversion devices 104 are sandwiched between a low-temperature side substrate 101 and a high-temperature side substrate 102 through joining materials 106 on electrodes 105 formed on the low-temperature side substrate 101 and the high-temperature side substrate 102. The low-temperature side substrate 101 and the high-temperature side substrate 102 are made of alumina (Al₂O₃). The electrodes 105 are made of copper (Cu). The joining material 106 is made of gold-tin solder. The power is generated by giving the temperature difference to the thermoelectric conversion module.

US2010/0252084 discloses a thermoelectric conversion module having substrates of differing thermal expansion coefficients.

### SUMMARY

However, when the temperature difference is given to the related-art thermoelectric module, there is a case where the stress caused by difference in thermal expansion between the high-temperature side and the low-temperature side is concentrated to the joining material, and electric connection between the joining material and the thermal electric conversion devices is broken, which may lead to a failure of the thermoelectric conversion module.

The present disclosure has been made in view of the above problems, and an object thereof is to suppress the generation of a failure in the thermoelectric conversion module due to the temperature difference.

According to an embodiment of the present disclosure, there is provided a thermoelectric conversion module including a first substrate, a second substrate facing the first substrate, a thermoelectric conversion device arranged between the first substrate and the second substrate, a first joining member arranged between the first substrate and the thermoelectric conversion device and a second joining member arranged between the second substrate and the thermoelectric conversion device in which a difference of thermal expansion coefficients between the first joining member and the first substrate is higher than a difference of thermal expansion coefficients between the second joining member and the second substrate, wherein a joining area between the second joining member and the second substrate is larger than a joining area between the first joining member and the first substrate.

According to the present disclosure, the thermoelectric conversion module and system suppressing the generation of a failure due to the temperature difference can be provided.

### BRIEF DESCRIPTION OF THE DRAWINGS

Fig. 1 is a schematic cross-sectional view showing a thermoelectric conversion module according to Embodiment 1;
Fig. 2 is a schematic cross-sectional view showing a fillet shape of a joining member according to Embodiment 1;
Fig. 3A is a schematic view showing a process of applying the joining member to an oxide ceramic substrate, Fig. 3B is a schematic view showing a process of mounting thermoelectric conversion devices and external terminals on the oxide ceramic substrate, Fig. 3C is a schematic view showing a process of applying the joining material to a nitride ceramic substrate and Fig. 3D is a schematic view showing a process of mounting the nitride ceramic substrate on the oxide ceramic substrate;
Fig. 4 is a schematic cross-sectional view showing a thermoelectric conversion module according to Embodiment 2;
Fig. 5 is a schematic cross-sectional view showing a thermoelectric conversion module according to Embodiment 3;

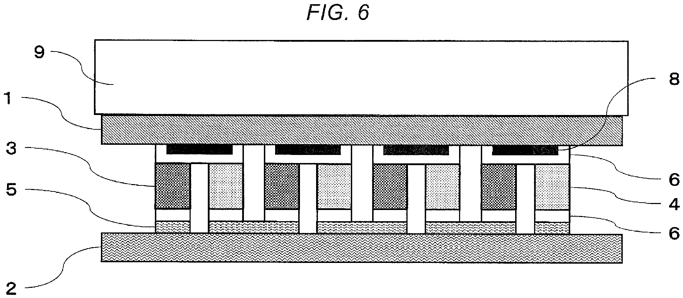

Fig. 6 is a schematic view showing a thermoelectric conversion system according to the embodiment; and
Fig. 7 is a schematic view showing a related-art thermoelectric conversion module.

### DESCRIPTION OF EMBODIMENTS

Hereinafter, embodiments will be explained with reference to the drawings. An application of power generation using Seebeck effect is assumed in the embodiment and, for example, heat is assumed to be received from a high-temperature heat source which forms a temperature difference of 300°C or more. However, the present disclosure is not limited to this, and the embodiment can be applied when the temperature difference is generated. That is, the same effects can be obtained by following the embodiments below and concepts thereof even in the case of temperature conditions of 300°C or less and in the case of a cooling application using Peltier effect.

### (Embodiment 1)

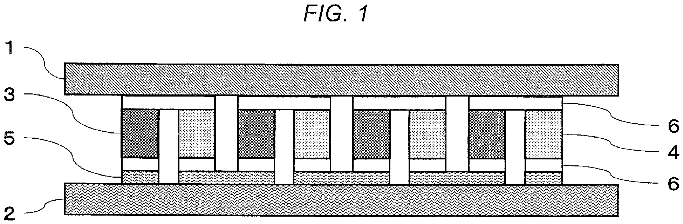

Fig. 1 is a schematic cross-sectional view of a thermoelectric conversion module according to Embodiment 1. A nitride ceramic substrate 1 is used as a first substrate and an oxide ceramic substrate 2 is used as a second substrate. The nitride ceramic substrate 1 is made of silicon nitride (Si₃N₄) or aluminum nitride (AlN). The oxide ceramic substrate 2 is made of alumina (Al₂O₃) or zirconium oxide (ZrO₂). The nitride ceramic substrate 1 is a substrate for being arranged in a higher temperature atmosphere than the oxide ceramic substrate 2.

The nitride ceramic substrate 1 and the oxide ceramic substrate 2 are arranged so as to face each other. P-type thermoelectric conversion devices 3 and N-type thermoelectric conversion devices 4 arranged inside these substrates are thermoelectric conversion devices which convert between heat and electricity.

The P-type thermoelectric conversion devices 3 are formed of thermoelectric conversion materials such as a zinc-antimony (Zn-Sb) alloy and a bismuth-tellurium (Bi-Te) alloy. The N-type thermoelectric conversion devices 4 are formed of thermoelectric conversion materials such as a cobalt-antimony (Co-Sb) alloy and the bismuth-tellurium (Bi-Te) alloy. The thermoelectric conversion materials may contain a small amount of additives.

An electrode 5 is formed on the oxide ceramic substrate 2, and a joining member 6 (second joining member) is arranged thereon. On the other hand, the electrode 5 does not exist on the nitride ceramic substrate 1. A joining member 6 (first joining member) formed in a wiring shape to have a function of the electrode is arranged so as to directly contact the nitride ceramic substrate 1. The P-type thermoelectric conversion devices 3 and the N-type thermoelectric conversion devices 4 are joined to both substrates through these joining members 6.

The joining members 6 are made of, for example, silver. The joining members 6 are formed by sintering a paste containing nanoparticles or submicron particles (hereinafter referred to as a nanoparticle paste for convenience), a detailed manufacturing method of which will be explained later.

The essence of the embodiment is that the nitride ceramic substrate 1 and the joining member 6 which are positioned in the high-temperature side are positively separated at an interface therebetween when the temperature difference is given. It is not necessary that respective substrates are joined to respective thermoelectric devices in terms of an electric circuit. That is because the thermoelectric conversion module normally functions as long as the P-type thermoelectric conversion devices 3 and the N-type thermoelectric conversion devices 4 are electrically connected through the electrode 5 and the bonding member 6. Accordingly, the module is configured so that the nitride ceramic substrate 1 and the joining member 6 are separated at the interface before breaking occurs at any of interfaces among the electrode 5, the joining member 6, the P-type thermoelectric conversion devices 3 and the N-type thermoelectric conversion devices 4, namely, before the stress concentration due to thermal expansion is generated at these interfaces. When the nitride ceramic substrate 1 and the joining member 6 are separated positively as described above, the stress concentration to respective devices and joined parts just below the substrate can be suppressed even when the nitride ceramic substrate 1 is thermally expanded.

Next, a structure for positively separating between the nitride ceramic substrate 1 and the joining member 6 at the interface will be explained.

When the temperature difference is given to upper and lower surfaces of the thermoelectric conversion module, thermal expansion occurs. The size of thermal expansion to be generated is determined by the temperature and thermal expansion coefficients of respective materials. Accordingly, the module is designed so that a large thermal stress acts on the interface between the nitride ceramic substrate 1 and the joining member 6.

Specifically, a thermal expansion coefficient of the nitride ceramic substrate 1 made of silicon nitride is approximately 3ppm. A thermal expansion coefficient of the joining member 6 made of silver is approximately 19ppm. In this case, the difference of thermal expansion coefficients of 16ppm is generated at the interface therebetween in accordance with the temperature in the high-temperature side.

When the nitride ceramic substrate 1 is made of nitride aluminum, a thermal expansion coefficient thereof is approximately 4. 5ppm. The thermal expansion coefficient is sufficiently small as compared with silver forming the joining member 6, and a large thermal stress acts on the interface therebetween as the temperature is increased.

The ceramic materials basically have smaller thermal expansion coefficients than the metal forming the joining member 6. However, a thermal expansion coefficient of alumina as an oxide ceramic is 7 ppm or more, and alumina expands twice or more as much as silicon nitride, therefore, the stress generated between alumina and the joining member 6 is 1/2 or less as compared with the case of silicon nitride. Accordingly, it is effective for increasing the stress added to the interface with respect to the joining member 6 by adopting the nitride ceramic for the substrate in the high-temperature side.

The thermal expansion coefficient is measured by a TMA (Thermal Mechanical Analysis) method following ISO17562-2001.

As the material of the joining member 6, silver is the most suitable. This is because silver has the lowest electrical resistivity in metals and the highest thermal expansion coefficient in precious metals. However, effects of the embodiment can be obtained when the joining member 6 is formed of gold (Au), palladium (Pd), platinum (Pt), copper (Cu) which have similar physical properties as silver or other precious metals (ruthenium (Ru), rhodium (Rh) and iridium (Ir) though the effects are inferior to silver. That is, the joining member 6 is preferably made of silver, gold, copper, palladium, platinum, ruthenium, rhodium, iridium or alloys containing any one of these metals as the main component. The main component indicates a component having the highest mass percentage occupied in materials forming the joining member 6.

Furthermore, the structure is devised to promote the breaking more at the interface by reducing the joining strength between the nitride ceramic substrate 1 and the joining member 6. The structure is devised in a point that the nanoparticle paste is sintered afterward on the nitride ceramic substrate 1 which has been already sintered to thereby form the joining member 6 by performing the formation of wiring and the joining of devices at the same time. Though the nanoparticle paste is joined to the nitride ceramic substrate 1 once by sintering, the joining strength is low. Therefore, when the interface is broken due to the thermal stress, the joining member 6 remains in the thermoelectric conversion devices' side which is joined more firmly, electric connection between devices are maintained and the function as the thermoelectric conversion module is maintained. When the nitride ceramic substrate 1 and the joining member 6 are formed at the same time by sintering a ceramic paste and a metal paste as LTCC (Low Temperature Co-fired Ceramics), a firm joined body is formed between elements forming the ceramic and metal elements forming the joining member 6, and it is difficult to positively break the nitride ceramic substrate 1 and the joining member 6 at the interface therebetween.

In the embodiment, the joining strength between the nitride ceramic substrate 1 and the joining member 6 is reduced to positively promote the breaking at the interface therebetween by adopting the method of sintering the joining member 6 on the ceramic substrate which has been already sintered.

The nanoparticle paste as the material is formed of a solvent, metal fine particles and a dispersant which covers the metal fine particles. However, only metal components remain as the joining member 6 as the solvent and the dispersant are volatilized at the time of heating and sintering. As a large remaining amount of the solvent or the dispersant means that sintering does not sufficiently progress, metal components contained in the joining member 6 for allowing the device to exist as a module are preferably 90 mass% or more.

It is important that the oxide ceramic substrate 2 arranged in the low-temperature side is stably joined to the thermoelectric conversion devices in contrast to the high-temperature side. This is because, when the thermoelectric conversion devices are completely separated from both substrates, the reliability with respect to vibration may be extremely deteriorated, which may lead to a failure of the thermoelectric conversion module. In particular, when the thermoelectric conversion module is applied to, for example, a vehicle, countermeasures for vibration are important. Accordingly, the oxide ceramic substrate 2 having a thermal expansion coefficient close to that of the joining member 6 is used for the opposite reason to the high-temperature side, thereby reducing the thermal stress generated at the interface therebetween when the temperature difference is given and maintaining the connection between the two.

Furthermore, the electrode 5 is formed over the oxide ceramic substrate 2. The electrode 5 is formed by sintering at the same time as ceramic as the above LTCC. The joining member 6 is formed over the electrode 5. The electrode 5 and the joining member 6 are made of the same metal material.

The effects obtained by the structure including the electrode 5 and the joining member 6 will be described below. In this case, the oxide ceramic substrate 2 is made of alumina, the joining member 6 is made of silver sintered by the nanoparticle paste and, and the electrode 5 is also made of silver.

In this case, as the joining member 6 and the electrode 5 are made of the same material, they can be regarded as being integrated. As the thermal expansion coefficients of the joining member 6 and the electrode 5 are also the same, the thermal stress is not generated at the interface.

As the thermal expansion coefficient of alumina is approximately 7ppm and the thermal expansion coefficient of silver is approximately 19ppm, the difference therebetween is approximately 12ppm. The value is smaller than the difference 16ppm as the thermal expansion coefficients between silver and the nitride ceramic. That is, the difference of thermal expansion coefficients between the joining member 6 and the nitride ceramic substrate 1 is larger than the difference of thermal expansion coefficients between the joining member 6 and the oxide ceramic substrate 2. Accordingly, the joining between the joining member 6 and the nitride ceramic substrate 1 can be broken while maintaining the joining between the joining member 6 and the oxide ceramic substrate 2 when the temperature difference is given. Moreover, the thermal stress is hardly generated at the interface between the joining member 6 and the oxide ceramic substrate 2 arranged in the lower-temperature side as compared with the case of the nitride ceramic substrate 1.

Note that the percentage of silicon nitride or aluminum nitride as the main component of materials forming the nitride ceramic substrate 1 which is occupied in all substrate materials is preferably higher than 90 mass%. This is because, when the percentage of the main component occupied in the whole material is 90 mass% or less, the thermal expansion coefficients deviate from the above values. Additionally, there also exists an adverse effect in which mechanical strength is reduced in a state where there are a large quantity of impurities with 90 mass% or less.

As the main component of materials forming the oxide ceramic substrate 2, alumina or zirconium oxide is adopted. It is preferable that the percentage of the oxide occupied in the entire substrate material is higher than 90 mass%. This is due to the same reason as the case of the nitride ceramic substrate 1.

Copper may be adopted as the electrode 5. As a thermal expansion coefficient of copper is approximately 17ppm, the difference between copper and silver is 2pm, therefore, a certain effect can be also obtained when adopting copper as the electrode 5 and applying silver to the joining member 6.

There exist interfaces between the thermoelectric conversion devices and the joining member in addition to joined parts (interfaces) with respect to the substrates in the thermoelectric conversion module. The thermoelectric conversion devices are made of materials containing a metal as a main component, and further, a barrier film made of, for example, nickel, molybdenum and so on may be disposed for preventing metal diffusion of the devices. A metal which is not easily oxidized, for example, silver may be stacked on the barrier film for improving the joining property with respect to the joining member 6. As the layer and the film are made of materials containing the metal as the main component, the firm joined part is formed by metal bonding. The joined part has a sufficiently strong joining strength as compared with the joined part between the ceramic substrates and the electrode 5 or the joining member 6, therefore, a place where the joining strength is particularly low in the thermoelectric conversion module, namely, the interface between the ceramic substrate and the metal (the electrode 5 or the joining member 6) is preferentially broken when the thermal stress is generated.

Accordingly, it is important in the embodiment to satisfy the relation of "the difference of thermal expansion coefficients between the joining member 6 and the nitride ceramic substrate 1 is higher than the difference of thermal expansion coefficients between the joining member 6 and the oxide ceramic substrate 2".

Furthermore, in the case where the joining member 6 in the nitride ceramic substrate 1 side and the joining member 6 in the oxide ceramic substrate 2 side are made of the same material, it is important to design respective members so that the relation that respective thermal expansion coefficients are "become smaller in order of the joining member 6, the oxide ceramic substrate 2 and the nitride ceramic substrate 1" is satisfied. Accordingly, it is possible to preferentially break the joined part (interface) between the joining member 6 and the nitride ceramic substrate 1 as compared with other interfaces when the temperature difference is given, which can prevent the failure of the thermoelectric conversion module.

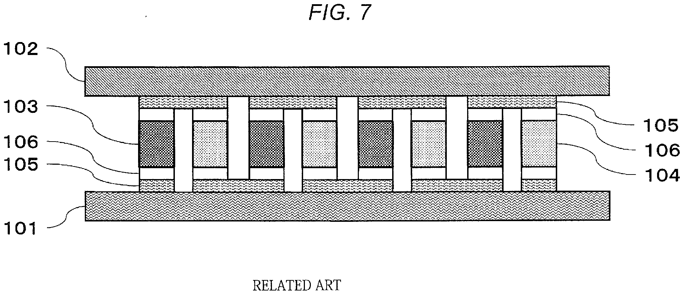

It has been confirmed that the thermoelectric module according to the embodiment hardly fails as compared with the related-art thermoelectric module (Fig. 7). Specifically, a heat cycle test in which the temperature in the low-temperature side was fixed to 100°C and the temperature in the high-temperature side was changed from 400°C to 100°C as one cycle was performed to verify presence of a failure. As a structure of the thermoelectric conversion module, the substrates of 30mm were used and the bismuth-tellurium (Bi-Te) alloy was used for the thermal conversion devices. The failure occurred due to the breaking at the joined part in five cycles in the related-art thermoelectric conversion module, however, it was confirmed that the power was normally generated after 100 cycles in the thermoelectric module according to the embodiment.

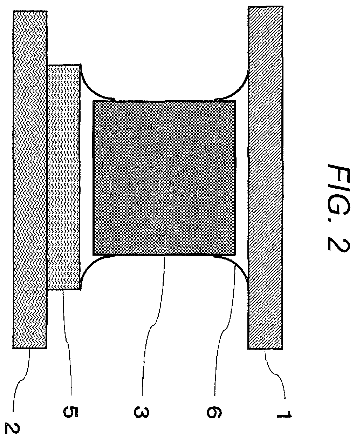

It is preferable that the joining member 6 has a shape reaching to side parts of the thermoelectric conversion devices. This is for increasing the joining strength between the thermoelectric conversion devices and the joining member 6. In this case, it is more preferable that the joining member 6 forms a fillet shape from the standpoint of increasing the joining strength. Fig. 2 shows a state in which the joining member 6 forms the fillet shape. Although the fillet shape with respect to the P-type thermoelectric conversion device 3 is shown, the same fillet shape is preferably formed with respect to the N-type thermoelectric conversion device.

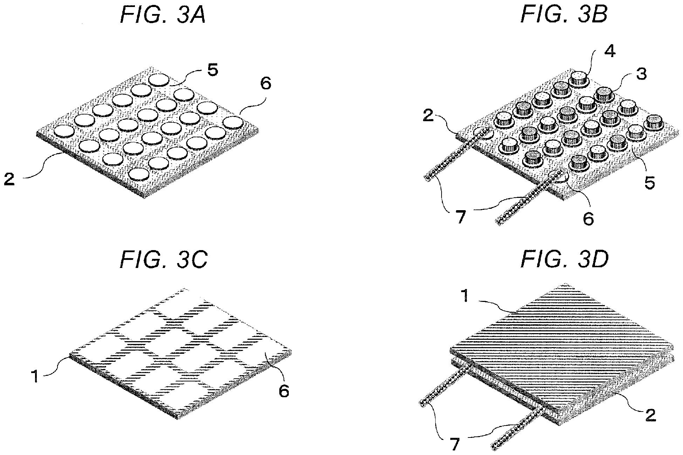

Next, a method of manufacturing the thermoelectric conversion module according to the embodiment will be explained with reference to Fig. 3A to Fig. 3D.

First, as shown in Fig. 3A, the joining member 6 is applied over the electrode 5 of the oxide ceramic substrate 2 so as to form a circuit pattern. The oxide ceramic substrate 2 and the electrode 5 are previously sintered at the same time, thereby firmly joining the two. In order to improve the joining property between the electrode 5 and the joining member 6, a film made of the same metal forming the bonding member 6 may be formed on the surface of the electrode 5. A thickness of the metal film is, for example, 30µm to 200µm.

Next, as shown in Fig. 3B, the P-type thermoelectric conversion devices 3 and the N-type thermoelectric conversion devices 4 and external terminals 7 are mounted on the oxide ceramic substrate 2. The P-type thermoelectric conversion devices 3 and the N-type thermoelectric conversion devices 4 are alternately mounted for connecting in series.

Next, as shown in Fig. 3C, the joining member 6 is applied over the nitride ceramic substrate 1. At this time, the electrode 5 does not exist on the nitride ceramic substrate 1, therefore, it is necessary that the joining member 6 functions as wiring. Accordingly, the joining member 6 is applied so that pairs of P-type thermoelectric conversion devices 3 and the N-type thermoelectric conversion devices 4 are electrically connected.

Next, as shown in Fig. 3D, the nitride ceramic substrate 1 is mounted on the oxide ceramic substrate 2.

After the joining member 6 is sintered after the above flow, the thermoelectric module is completed. When the joining member 6 is the nanoparticle paste of silver, the sintering is performed, for example, at 250°C for 30min to 60min.

### (Embodiment 2)

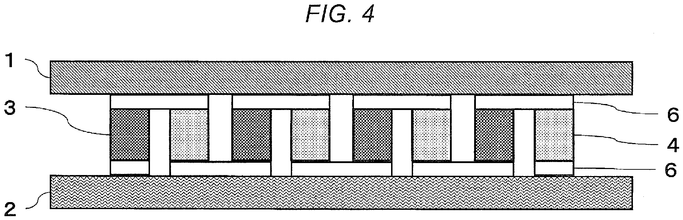

Fig. 4 is a schematic cross-sectional view of a thermal conversion module according to Embodiment 2. The embodiment differs from Embodiment 1 in a point that the oxide ceramic substrate 2 and the thermoelectric conversion devices are joined by the joining member 6 without providing the electrode 5.

The inventors have found that the joining strength differs in the nitride ceramic substrate 1 and the oxide ceramic substrate 2 when the joining member 6 is formed of the nanoparticle paste. This is because nitrogen (N) of the nitride ceramic substrate 1, oxygen (O) of the oxide ceramic substrate 2 and the metal of the joining member 6 have different affinities. In this case, the oxide ceramic substrate 2 is joined to the joining member 6 more firmly than the nitride ceramic substrate 1. Specifically, it has been confirmed that alumina generates a joining strength 1.5 times as much as silicon nitride. The oxide ceramic substrate 2 and the joining member 6 are directly joined by utilizing the characteristic, thereby breaking the joined part between the nitride ceramic substrate 1 and the joining member 6 while maintaining the joining between the joining member 6 and the oxide ceramic substrate 2. The joining member 6 is arranged in a pattern shape for forming wiring.

When forming the electrode 5 as shown in Fig. 1, the metal diffusion may significantly proceed and there is a risk that the joining strength is reduced. Accordingly, it is possible to reduce the risk of metal diffusion by omitting the electrode 5.

The joining area between the bonding member 6 and the oxide ceramic substrate 2 is larger than the joining area between the joining member 6 and the nitride ceramic substrate 1. According to the structure, it is possible to positively break the joined part between the joining member 6 and the nitride ceramic substrate 1 when the temperature difference is given while firmly joining between the joining member 6 and the oxide ceramic substrate 2.

### (Embodiment 3)

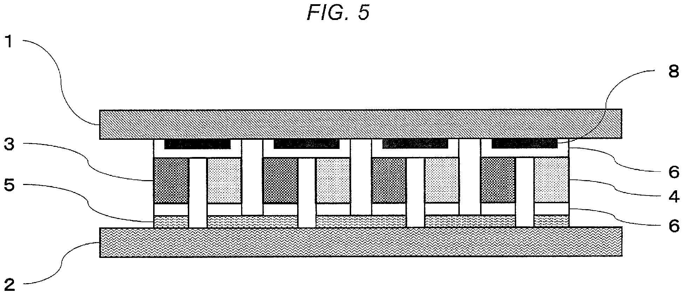

Fig. 5 is a schematic cross-sectional view of a thermal conversion module according to Embodiment 3. The embodiment differs from Embodiment 1 in a point that a wiring member 8 is arranged in the nitride ceramic substrate 1 side with the joining member 6.

Although the power generation can be also increased by increasing the temperature difference as described above, the stress acting on the inside of the module is also increased in proportion to the temperature difference in that case. In the case where wiring is formed only by the joining member 6, cracks due to the repeated expansion and contraction may occur or deterioration such as abrasion caused by friction with the nitride ceramic substrate 1 may occur. In this case, the reliability is improved by arranging the wiring member 8 as a reinforcement.

As the wiring member 8, a bulk material which is the same material as the joining member 6 is preferably used from the viewpoint of integrity of strength, the joining property and the thermal expansion coefficient. The shape thereof can be also changed appropriately in accordance with the operating temperature and the type of the joining member 6 as long as the reinforcing effect of the joining member 6 functioning as wiring can be obtained.

Even in the case where the wiring member 8 is disposed as in the embodiment, the bonding member 6 is important as part thereof contacts the nitride ceramic substrate 1. This is because the joining member 6 and the nitride ceramic substrate 1 are joined before operation and the interface therebetween is separated due to the thermal stress at the time of operation, thereby obtaining effects of the present disclosure.

A thermoelectric conversion system can be constructed to include the thermoelectric conversion module according to Embodiments 1 to 3 and a heat source arranged in the nitride ceramic substrate 1 side. According to the system, it is possible to prevent the failure of the thermoelectric conversion module at the time of operation (when the temperature difference is given) and to keep the reliability of the system itself high.

The heat source may be a pipe through which fluid passes. This is because the thermoelectric conversion module hardly fails when vibration generated when the fluid passes is added. The fluid may be an exhaust gas. Even when an enormous thermal stress is added in a high-temperature atmosphere exceeding 300°C such as the exhaust gas, the thermoelectric conversion module and the system have a durable property.

Here, a schematic view of a thermoelectric conversion system 11 is shown in Fig. 5. The thermoelectric conversion system 11 is configured by including the thermoelectric conversion module according to Embodiment 3 and the heat source 9 arranged in the nitride ceramic substrate 1 side. The above effects can be obtained by this system. The thermoelectric conversion module according to Embodiment 1 or 2 may be applied to the system.

## Claims

1. A thermoelectric conversion module comprising:
a first substrate (1);
a second substrate (2) facing the first substrate;
a thermoelectric conversion device (3,4) arranged between the first substrate and the second substrate;
a first joining member (6) arranged between the first substrate (1) and the thermoelectric conversion device (3,4); and
a second joining member (6) arranged between the second substrate (2) and the thermoelectric conversion device (3,4);
wherein the first joining member (6) contacts the first substrate (1), and
a difference of thermal expansion coefficients between the first joining member (6) and the first substrate (1) is higher than a difference of thermal expansion coefficients between the second joining member (6) and the second substrate (2),
**characterized in that** a joining area between the second joining member (6) and the second substrate (2) is larger than a joining area between the first joining member (6) and the first substrate (1).

2. The thermoelectric conversion module according to claim 1, further comprising:
a wiring member (8) arranged between the first substrate (1) and the thermoelectric conversion device (3,4).

3. The thermoelectric conversion module according to claim 1,
wherein the second joining member (6) contacts the second substrate (2).

4. The thermoelectric conversion module according to claim 1,
wherein the first and second joining members are the same material.

5. The thermoelectric conversion module according to claim 1,
wherein the thermal expansion coefficients become smaller in order of the first joining member (6), the second substrate (2) and the first substrate (1).

6. The thermoelectric conversion module according to claim 1,
wherein the first substrate (1) is a nitride ceramic.

7. The thermoelectric conversion module according to claim 6,
wherein the nitride ceramic is a silicon nitride or an aluminum nitride.

8. The thermoelectric conversion module according to claim 1,
wherein the second substrate (2) is an oxide ceramic.

9. The thermoelectric conversion module according to claim 8,
wherein the oxide ceramic is an alumina or a zirconium oxide.

10. The thermoelectric conversion module according to claim 1,
wherein the first joining member (6) is silver, gold, copper, palladium, platinum, ruthenium, rhodium, iridium, or alloys containing any one of these metals as the main component.

11. The thermoelectric conversion module according to claim 10,
wherein the first joining member (6) comprises sintered nanoparticle or submicron particles.

12. The thermoelectric conversion module according to claim 1,
wherein the first substrate (1) is a substrate configured to be in a higher temperature atmosphere than a temperature of the second substrate (2).

13. The thermoelectric conversion module according to claim 1,
wherein the first joining member (6) is in direct contact with the first substrate (1).

14. The thermoelectric conversion module according to claim 1,
wherein the second joining member (6) is in direct contact with the second substrate (2).

15. A thermoelectric conversion system comprising:
the thermoelectric module according to claim 1; and
a heat source arranged in a side of the first substrate.

16. The thermoelectric conversion system according to claim 15,
wherein the heat source is a pipe through which a fluid passes.

## Patentansprüche

1. Modul für thermoelektrische Umwandlung, aufweisend:
ein erstes Substrat (1);
ein zweites Substrat (2), das zum ersten Substrat gerichtet ist;
eine thermoelektrische Umwandlungsvorrichtung (3, 4), die zwischen dem ersten Substrat und dem zweiten Substrat angeordnet ist;
ein erstes Verbindungselement (6), das zwischen dem ersten Substrat (1) und der thermoelektrischen Umwandlungsvorrichtung (3, 4) angeordnet ist; und
ein zweites Verbindungselement (6), das zwischen dem zweiten Substrat (2) und der thermoelektrischen Umwandlungsvorrichtung (3, 4) angeordnet ist;
wobei das erste Verbindungselement (6) mit dem ersten Substrat (1) in Kontakt ist, und
eine Differenz der thermischen Ausdehnungskoeffizienten zwischen dem ersten Verbindungselement (6) und dem ersten Substrat (1) größer ist als eine Differenz der thermischen Ausdehnungskoeffizienten zwischen dem zweiten Verbindungselement (6) und dem zweiten Substrat (2),
**dadurch gekennzeichnet, dass** eine verbindende Fläche zwischen dem zweiten Verbindungselement (6) und dem zweiten Substrat (2) größer ist als eine verbindende Fläche zwischen dem ersten Verbindungselement (6) und dem ersten Substrat (1).

2. Modul für thermoelektrische Umwandlung nach Anspruch 1, ferner aufweisend:
ein Verdrahtungselement (8), das zwischen dem ersten Substrat (1) und der thermoelektrischen Umwandlungsvorrichtung (3, 4) angeordnet ist.

3. Modul für thermoelektrische Umwandlung nach Anspruch 1,
wobei das zweite Verbindungselement (6) mit dem zweiten Substrat (2) in Kontakt ist.

4. Modul für thermoelektrische Umwandlung nach Anspruch 1,
wobei die ersten und zweiten Verbindungselemente aus dem gleichen Material sind.

5. Modul für thermoelektrische Umwandlung nach Anspruch 1,
wobei die thermischen Ausdehnungskoeffizienten in der Reihenfolge erstes Verbindungselement (6), zweites Substrat (2) und erstes Substrat (1) kleiner werden.

6. Modul für thermoelektrische Umwandlung nach Anspruch 1,
wobei das erste Substrat (1) eine Nitridkeramik ist.

7. Modul für thermoelektrische Umwandlung nach Anspruch 6,
wobei die Nitridkeramik ein Siliziumnitrid oder ein Aluminiumnitrid ist.

8. Modul für thermoelektrische Umwandlung nach Anspruch 1,
wobei das zweite Substrat (2) eine Oxidkeramik ist.

9. Modul für thermoelektrische Umwandlung nach Anspruch 8,
wobei die Oxidkeramik ein Aluminium- oder ein Zirkonoxid ist.

10. Modul für thermoelektrische Umwandlung nach Anspruch 1,
wobei das erste Verbindungselement (6) aus Silber, Gold, Kupfer, Palladium, Platin, Ruthenium, Rhodium, Iridium oder mindestens eines dieser Metalle als Hauptkomponente enthaltenden Legierungen sind.

11. Modul für thermoelektrische Umwandlung nach Anspruch 10,
wobei das erste Verbindungselement (6) gesinterte Nanopartikel oder Submikropartikel aufweist.

12. Modul für thermoelektrische Umwandlung nach Anspruch 1,
wobei das erste Substrat (1) ein Substrat ist, das konfiguriert ist, um in einer höheren Temperaturatmosphäre zu sin als das zweite Substrat (2).

13. Modul für thermoelektrische Umwandlung nach Anspruch 1,
wobei das erste Verbindungselement (6) Direktkontakt mit dem ersten Substrat (1) hat.

14. Modul für thermoelektrische Umwandlung nach Anspruch 1,
wobei das zweite Verbindungselement (6) Direktkontakt mit dem zweiten Substrat (2) hat.

15. System für thermoelektrische Umwandlung, aufweisend:
das Modul für thermoelektrische Umwandlung nach Anspruch 1; und
eine in einer Seite des ersten Substrats angeordnete Wärmequelle.

16. System für thermoelektrische Umwandlung nach Anspruch 15,
wobei die Wärmequelle ein von einem Fluid durchströmtes Rohr ist.

## Revendications

1. Module de conversion thermoélectrique comprenant :
un premier substrat (1) ;
un second substrat (2) faisant face au premier substrat ;
un dispositif de conversion thermoélectrique (3, 4) disposé entre le premier substrat et le second substrat ;
un premier élément de jonction (6) disposé entre le premier substrat (1) et le dispositif de conversion thermoélectrique (3, 4) ; et
un second élément de jonction (6) disposé entre le second substrat (2) et le dispositif de conversion thermoélectrique (3, 4) ;
dans lequel le premier élément de jonction (6) entre en contact avec le premier substrat (1), et
une différence de coefficients de dilatation thermique entre le premier élément de jonction (6) et le premier substrat (1) est supérieure à une différence de coefficients de dilatation thermique entre le second élément de jonction (6) et le second substrat (2),
**caractérisé en ce qu'**une zone de jonction entre le second élément de jonction (6) et le second substrat (2) est supérieure à une zone de jonction entre le premier élément de jonction (6) et le premier substrat (1).

2. Module de conversion thermoélectrique selon la revendication 1, comprenant en outre :
un élément de câblage (8) disposé entre le premier substrat (1) et le dispositif de conversion thermoélectrique (3, 4).

3. Module de conversion thermoélectrique selon la revendication 1,
dans lequel le second élément de jonction (6) entre en contact avec le second substrat (2).

4. Module de conversion thermoélectrique selon la revendication 1,
dans lequel les premier et second éléments de jonction sont du même matériau.

5. Module de conversion thermoélectrique selon la revendication 1,
dans lequel les coefficients de dilatation thermique diminuent dans l'ordre depuis le premier élément de jonction (6), le second substrat (2) et le premier substrat (1).

6. Module de conversion thermoélectrique selon la revendication 1,
dans lequel le premier substrat (1) est une céramique à base de nitrure.

7. Module de conversion thermoélectrique selon la revendication 6,
dans lequel la céramique à base de nitrure est un nitrure de silicium ou un nitrure d'aluminium.

8. Module de conversion thermoélectrique selon la revendication 1,
dans lequel le second substrat (2) est une céramique à base d'oxyde.

9. Module de conversion thermoélectrique selon la revendication 8,
dans lequel la céramique à base d'oxyde est une alumine ou un oxyde de zirconium.

10. Module de conversion thermoélectrique selon la revendication 1,
dans lequel le premier élément de jonction (6) est en argent, en or, en cuivre, en palladium, en platine, en ruthénium, en rhodium, en iridium ou en alliages contenant l'un quelconque de ces métaux comme composant principal.

11. Module de conversion thermoélectrique selon la revendication 10,
dans lequel le premier élément de jonction (6) comprend des nanoparticules frittées ou des particules submicroniques.

12. Module de conversion thermoélectrique selon la revendication 1,
dans lequel le premier substrat (1) est un substrat configuré pour être dans une atmosphère à température supérieure à une température du second substrat (2).

13. Module de conversion thermoélectrique selon la revendication 1,
dans lequel le premier élément de jonction (6) est en contact direct avec le premier substrat (1).

14. Module de conversion thermoélectrique selon la revendication 1,
dans lequel le second élément de jonction (6) est en contact direct avec le second substrat (2).

15. Système de conversion thermoélectrique comprenant :
le module thermoélectrique selon la revendication 1 ; et
une source de chaleur disposée dans un côté du premier substrat.

16. Système de conversion thermoélectrique selon la revendication 15,
dans lequel la source de chaleur est un tuyau à travers lequel passe un fluide.
